# EUROPEAN PATENT APPLICATION

(11) **EP 2 662 967 A1**
(43) Date of publication of application: **13.11.2013**
(21) Application number: 13164883.4
(22) Date of filing: 23.04.2013
(51) Int. Cl.: H02M 7/00, B60L 3/00

(54) **Power conversion apparatus**

(30) Priority: 09.05.2012 JP 2012108010; 05.02.2013 JP 2013020439
(71) Applicant: Kabushiki Kaisha Yaskawa Denki, Kitakyushu-shi, Fukuoka 806-0004 (JP)
(72) Inventor: Ito, Tetsuya, Kitakyushu-shi, Fukuoka 806-0004 (JP)
(74) Representative: Grünecker, Kinkeldey, Stockmair & Schwanhäusser

(57) **Abstract**

A power conversion apparatus (10) according to an embodiment includes a cooling jacket (21). The cooling jacket (21) includes a mounting face on which a power module (11c) including a power semiconductor device is mounted, a plurality of radiation fins (21c) that are arranged along a predetermined direction over the substantially whole area of the back side of the mounting face, and a boss (21b) that is placed along the predetermined direction in the central area of the substantially whole area of the back side.

## Description

### FIELD

The embodiment discussed herein is directed to a power conversion apparatus.

### BACKGROUND

There is known a conventional power conversion apparatus that is mounted on a hybrid car and an electric vehicle to be used for drive control of a traction motor. The power conversion apparatus converts DC power of a battery into three-phase AC power to drive the traction motor and also returns regenerative electric power of the traction motor to the battery during rapid deceleration.

The power conversion apparatus mounts thereon power semiconductor devices such as insulated gate bipolar transistors (IGBT) and also mounts thereon power modules that are serially arranged, in order to perform the three-phase AC power conversion by using the power modules.

Because the power modules control large currents to drive the traction motor, the power modules have very large heat quantity. For this reason, it is normal that the power conversion apparatus includes a cooling mechanism for the power modules.

The cooling mechanism employs a water-cooling type with a high cooling efficiency in many cases in order to efficiently perform cooling on a limited mounting space in a hybrid car or an electric vehicle.

For example, power (semiconductor) modules disclosed in Japanese Laid-open Patent Publication No. 2008-311550 are serially arranged on the surface side of a base plate. On the back side of the base plate, radiation fins, which extend parallel along the array direction of the power modules, are provided to be integrated with the base plate.

A cooling jacket is fixed onto the back side of the base plate to cover the radiation fins. As a result, a cooling medium channel into which a cooling medium flows through between the radiation fins is formed between the base plate and the cooling jacket.

The conventional power conversion apparatus has further room for improvement in that balance between cooling efficiency and pressure loss of the cooling mechanism is required. More specifically, as described above, in case of the cooling mechanism that makes the cooling medium flow through between the radiation fins, the flow velocity of the cooling medium is quickened by increasing the number of radiation fins and thus cooling efficiency is enhanced. However, there is a problem that a pressure loss is also increased at the same time.

An aspect of an embodiment has been achieved in view of the above problem, and an object of the embodiment is to provide a power conversion apparatus that can keep balance between cooling efficiency and pressure loss of the cooling mechanism.

### SUMMARY

A power conversion apparatus according to an embodiment includes a cooling jacket. The cooling jacket includes a mounting face on which a power module including a power semiconductor device is mounted, a plurality of radiation fins that are arranged along a predetermined direction over a substantially whole area of a back side of the mounting face, and a boss that is placed along the predetermined direction in a central area of the substantially whole area of the back side.

According to an aspect of an embodiment, it is possible to keep balance between cooling efficiency and pressure loss of the cooling mechanism.

### BRIEF DESCRIPTION OF DRAWINGS

FIG. 1A is a schematic diagram illustrating the configuration of a motor drive system that includes a power conversion apparatus according to an embodiment.

FIG. 1B is a schematic perspective diagram illustrating the configuration of the power conversion apparatus according to the embodiment.

FIG. 1C is a schematic diagram illustrating a circulatory system for cooling water.

FIG. 2A is a cross-sectional view when viewed from the A-A' line of FIG. 1B.

FIG. 2B is an enlarged schematic diagram of an M1 part illustrated in FIG. 2A.

FIG. 3A is a schematic perspective diagram illustrating the configuration of a power module.

FIG. 3B is a schematic plan view illustrating the configuration of the power module.

FIG. 4A is a schematic perspective diagram viewed from the surface side of a cooling jacket.

FIG. 4B is a schematic perspective diagram viewed from the back side of the cooling jacket.

FIG. 5 is a schematic diagram explaining an effect obtained by a boss.

FIG. 6A is a schematic diagram illustrating an alternative example in which a dummy boss is provided.

FIG. 6B is a schematic diagram illustrating an alternative example in which a water-supply pipe and a drainage pipe are arranged opposite each other.

FIGS. 7A and 7B are diagrams illustrating preconditions of a first validation example.

FIGS. 8A to 8D are diagrams illustrating preconditions of a second validation example.

### DESCRIPTION OF EMBODIMENT

Hereinafter, a power conversion apparatus according to an embodiment of the present disclosure will be explained in detail with reference to the accompanying drawings. In addition, the embodiment disclosed below is not intended to limit the present invention.

Hereinafter, a power conversion apparatus that processes a three-phase alternating current will be explained as an example. Herein, it is assumed that a power module is an IGBT module that includes IGBT as a switching element. A cooling medium may be referred to as "cooling water". Herein, "cooling water" is an example of coolant that includes water or a cooling medium other than water.

In order to make an explanation understandable, each drawing that is used for the following explanations may show a three-dimensional rectangular coordinate system that includes the Z-axis whose vertically upward direction is a positive direction and whose vertically downward direction is a negative direction. In the present embodiment, the positive direction of X-axis in the rectangular coordinate system is defined as the front direction of the power conversion apparatus.

Hereinafter, only one of components has a reference number and the reference numbers of the other components may be omitted. In this case, one component with a reference number and the other components have the same configuration.

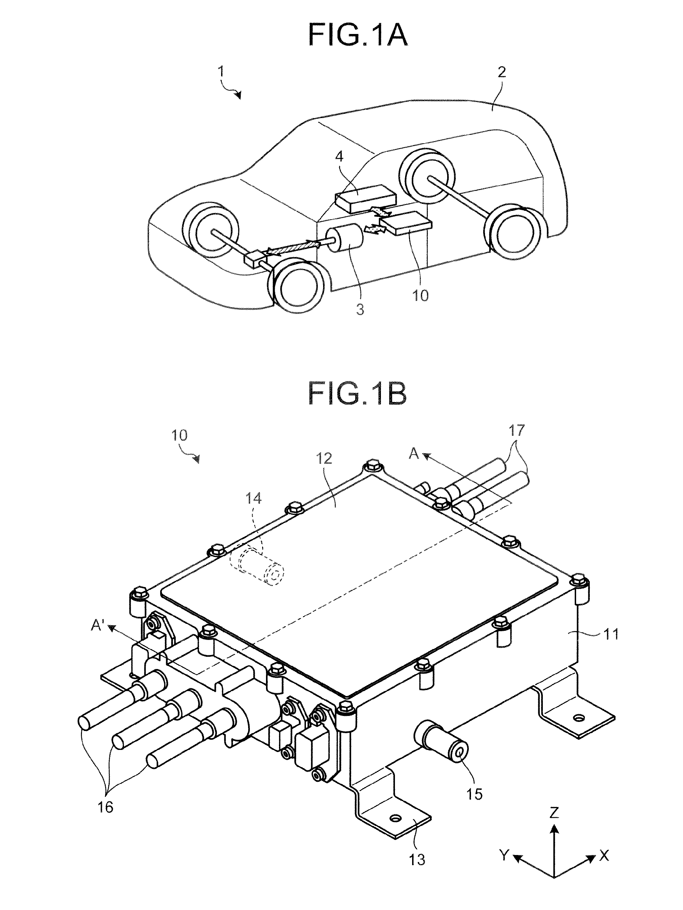

FIG. 1A is a schematic diagram illustrating the configuration of a motor drive system 1 that includes a power conversion apparatus 10 according to the embodiment. As illustrated in FIG. 1A, the motor drive system 1 includes a vehicle 2, a traction motor 3, a battery 4, and the power conversion apparatus 10.

The vehicle 2 is an automobile, such as a hybrid car and an electric vehicle, which has an electric motor (in other words, the traction motor 3 to be described later) as a power source of a drive system.

The traction motor 3 is a power source of a drive system of the vehicle 2 and is configured of an IPM motor (Interior Permanent Magnet Motor) and the like. Although the case where the driving method of the drive system is front-wheel drive is illustrated in FIG. 1A, the driving method of the vehicle 2 is not limited to this.

The battery 4 is a so-called secondary battery that supplies power to the traction motor 3 via the power conversion apparatus 10 and accumulates regenerative electric power via the power conversion apparatus 10.

The power conversion apparatus 10 converts DC power from the battery 4 into three-phase AC power to drive the traction motor 3. Moreover, the power conversion apparatus 10 returns regenerative electric power of the traction motor 3 to the battery 4 during rapid deceleration to charge the battery 4. When the vehicle 2 is a hybrid car, the power conversion apparatus 10 charges the battery 4 with power from the traction motor 3 that acts as an electric generator during normal running by an engine.

Next, the configuration of the power conversion apparatus 10 will be explained with reference to FIG. 1B. FIG. 1B is a schematic perspective diagram illustrating the configuration of the power conversion apparatus 10 according to the embodiment. As illustrated in FIG. 1B, the power conversion apparatus 10 includes a case 11, a cover 12, a bracket 13, a water-supply pipe 14, and a drainage pipe 15.

The case 11 is a housing that has a substantially rectangular-solid shape and whose upper surface is opened. The case 11 houses a power module, a cooling mechanism, and the like to be described later. The cover 12 is fixed onto the upper surface of the opened case 11.

The bracket 13 is a support of the power conversion apparatus 10 when the power conversion apparatus 10 is mounted on the vehicle 2.

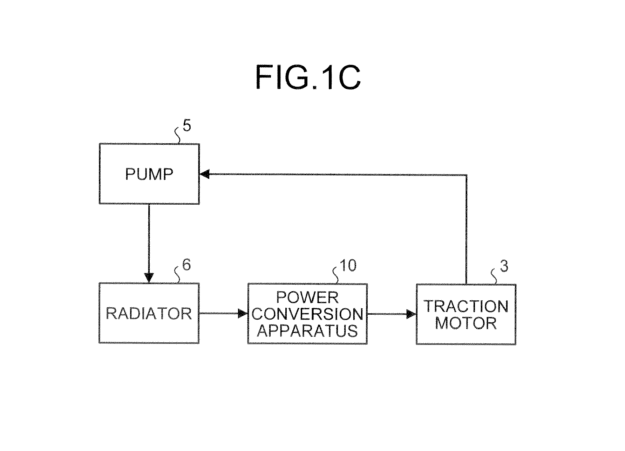

The water-supply pipe 14 is a feed-water inlet of cooling water that is supplied from a pump 5 (see FIG. 1C) for cooling water circulation. The drainage pipe 15 is a drainage outlet of cooling water that is provided on a surface opposite the surface on which the water-supply pipe 14 is provided. As illustrated in FIG. 1B, in the present embodiment, the water-supply pipe 14 and the drainage pipe 15 are arranged alternately to be diagonally opposite each other.

The power conversion apparatus 10 is connected to the traction motor 3 via a motor cable 16. The power conversion apparatus 10 is further connected to the battery 4 via a battery cable 17.

Herein, a circulatory system for cooling water is explained with reference to FIG. 1C. FIG. 1C is a schematic diagram illustrating a circulatory system for cooling water. In this case, arrows illustrated in FIG. 1C indicates the flow direction of cooling water.

As illustrated in FIG. 1C, the circulatory system for cooling water includes the pump 5, a radiator 6, the power conversion apparatus 10, and the traction motor 3.

First, cooling water is sent out from the pump 5 to the radiator 6, and its heat is radiated in the radiator 6. After that, the cooling water is supplied to the power conversion apparatus 10. In the power conversion apparatus 10, the power module is cooled by using the supplied cooling water. The cooling water is further sent out from the power conversion apparatus 10 to the traction motor 3.

Then, the traction motor 3 is also cooled by the cooling water. After that, the cooling water is returned from the traction motor 3 to the pump 5. The cooling water circulates through the circulatory system. Therefore, for example, reducing a pressure loss of the cooling mechanism of the power conversion apparatus 10 in the circulatory system conduces to load reduction of the pump 5, the reduction of power consumption, and the miniaturization of the pump 5.

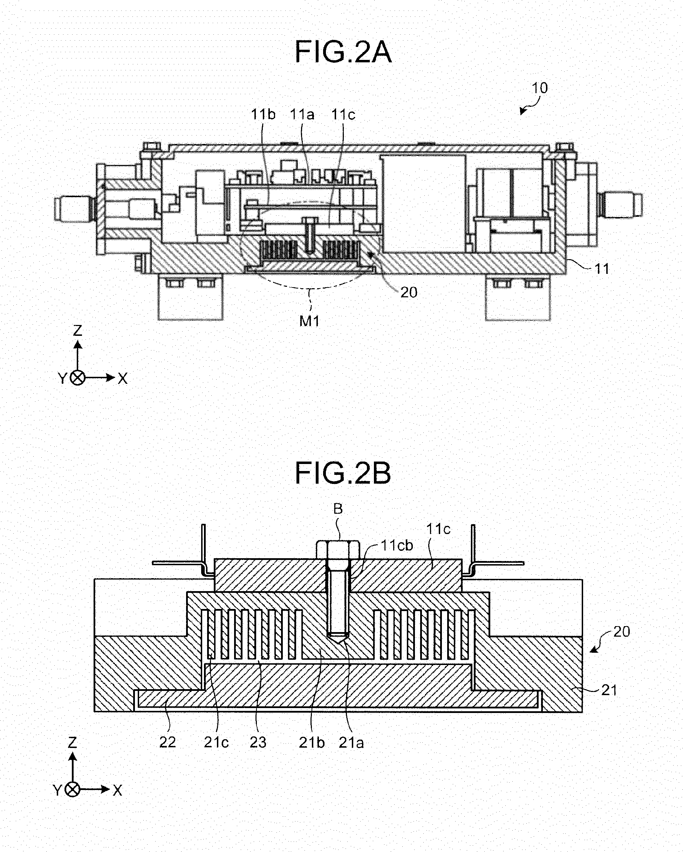

Next, the configuration of the power conversion apparatus 10 will be explained further in detail with reference to FIG. 2A that is a cross-sectional view viewed from the A-A' line of FIG. 1B and FIG. 2B that is an enlarged view of an M1 part illustrated in FIG. 2A.

As illustrated in FIG. 2A, the power conversion apparatus 10 includes, inside the case 11, a control board 11a a gate board 11b, a power module 11c, and a cooling mechanism 20. Herein, the power module 11c is an example of a power conversion means. The cooling mechanism 20 is an example of a cooling means.

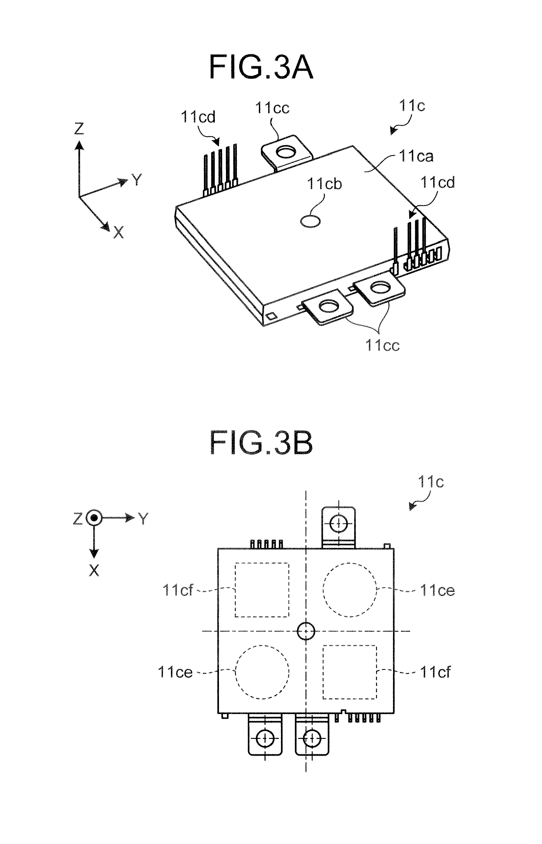

Herein, before it is explained with reference to FIG. 2B, the detailed configuration of the power module 11c will be explained with reference to FIGS. 3A and 3B. FIG. 3A is a schematic perspective diagram illustrating the configuration of the power module 11c. FIG. 3B is a schematic plan view illustrating the configuration of the power module 11c.

As illustrated in FIG. 3A, the power module 11c is a module that is obtained by packaging electronic components, which include a power semiconductor device (hereinafter, "semiconductor device"), with molding resin 11ca. A bolt hole 11cb that is a through-hole is formed in the central portion of the principal surface of the power module 11c.

Main terminals 11cc and control terminals 11cd are provided on the power module 11c.

As illustrated in FIG. 3B, a pair of switching elements 11ce and a pair of rectifying devices 11cf are alternately arranged inside the power module 11c. Herein, main heating elements of the power module 11c are the switching elements 11ce. Therefore, heating regions of the power module 11c are allocated on the left and right areas of the power module 11c while placing the central portion of the principal surface of the power module 11c therebetween.

The switching elements 11ce are illustrated as a perfect circle and the rectifying devices 11cf are illustrated as a rectangle in FIG. 3B. Its object is to identify them. Therefore, the embodiment is not limited to these shapes.

In the present embodiment, it has been explained that the rectifying devices 11cf are free wheeling diodes (FWDi). However, this point does not limit the type of the rectifying device 11cf.

In the present embodiment, the one power module 11c processes a single-phase alternating current of a three-phase alternating current. Therefore, the three power modules 11c become necessary to treat a three-phase alternating current.

Returning to FIG. 2B, the cooling mechanism 20 will be explained. As illustrated in FIG. 2B, the cooling mechanism 20 includes a cooling jacket 21. The cooling jacket 21 is an example of a channel formation means.

A hole 21a is formed on the surface side of the cooling jacket 21. Moreover, a boss 21b that is a substantially cylindrical protrusion is formed on the back side of the cooling jacket 21 in a region around the hole 21a.

Herein, the power module 11c is mounted on the surface side of the cooling jacket 21 by threadedly engaging a bolt B (fastening member) with the hole 21a via the above bolt hole 11cb (see FIG. 3A). In other words, the surface side of the cooling jacket 21 is the mounting face of the power module 11c. Herein, the bolt B is an example of a fixing means. The mounting face of the power module 11c is an example of a mounting means. Moreover, the boss 21b is an example of a separating means for fixing the fixing means and separating a cooling medium.

As illustrated in FIG. 2B, a plurality of radiation fins 21c are formed in the (substantially) whole area of the back side of the mounting face of the power module 11c in the cooling jacket 21 in accordance with the length of protrusion of the boss 21b to extend parallel along Y-axis of the diagram.

Herein, "the (substantially) whole area of the back side" described above means an area in which cooling medium channels are provided in the back side of the mounting face on which the power module 11c is mounted.

Moreover, "parallel" described above means the same direction. Moreover, "the length of protrusion" means a length from the root position to the leading end of the boss 21b and the radiation fins 21c. Herein, the radiation fins 21c are an example of a heat radiation means.

The cooling jacket 21 is die-cast from material such as aluminum having high thermal conductivity. Therefore, the hole 21a, the boss 21b, and the radiation fins 21c are integrated with the cooling jacket 21.

A cover 22 is mounted on the back side of the cooling jacket 21 at a predetermined gap from the boss 21b and the radiation fins 21c. Herein, a space between the cooling jacket 21 and the cover 22 is sealed by junction, a gasket, or the like.

As a result, a cooling medium channel 23 including the above predetermined gap is formed, and thus cooling water flows through the cooling medium channel 23. Hereinafter, a direction along Y-axis of the diagram may be referred to as a "predetermined direction".

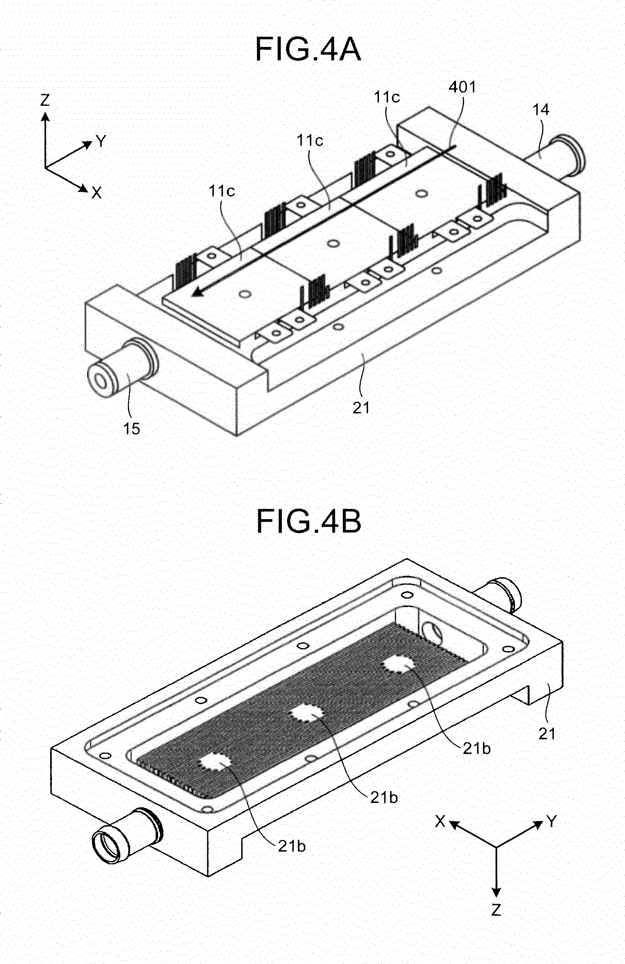

Herein, the total configuration of the cooling jacket 21 based on the above explanations will be explained with reference to FIGS. 4A and 4B. FIG. 4A is a schematic perspective diagram viewed from the surface side of the cooling jacket 21. FIG. 4B is a schematic perspective diagram viewed from the back side of the cooling jacket 21.

As illustrated in FIG. 4A, when the power conversion apparatus 10 treats a three-phase alternating current, the three power modules 11c are serially arranged on the cooling jacket 21 side by side along Y-axis of the diagram. This point is similar to a case where the power modules are applied to a six-phase alternating current, for example. In this case, the six power modules 11c are serially arranged side by side.

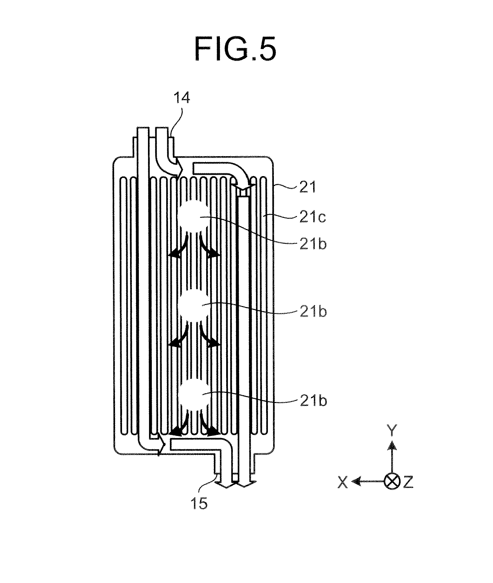

Cooling water from the water-supply pipe 14 flows along a flow direction indicated by an arrow 401 of the diagram and is drained from the drainage pipe 15. Although the flow direction of cooling water is roughly indicated by the linear arrow 401 in FIG. 4A, the flow direction (and flow velocity) can be strictly adjusted by the boss 21b provided in the cooling jacket 21 to keep balance of cooling efficiency and pressure loss and to effectively cool the power module 11c. The details of this point are explained below with reference to FIG. 5.

Because the boss 21b is associated with the bolt hole 11cb provided in the central portion of the power module 11c (see FIG. 2B), the bosses 21b are arranged on central areas of the back side of the cooling jacket 21 along Y-axis of the diagram, as illustrated in FIG. 4B. Next, an effect obtained by the arrangement of the bosses 21b as described above will be explained with reference to FIG. 5.

FIG. 5 is a schematic diagram explaining an effect obtained by the bosses 21b. As illustrated in FIG. 5, the bosses 21b are arranged on the central areas of the back side of the cooling jacket 21 along Y-axis of the diagram, and thus the cooling water from the water-supply pipe 14 is easy to be separated into the left and right areas of the cooling jacket 21 (see white-space arrows in the diagram).

This means that the flow velocity of cooling water is easy to increase in the left and right areas of the cooling jacket 21, that is to say, that cooling efficiency is easy to improve in the left and right areas of the cooling jacket 21.

As already explained above with reference to FIG. 3B, the main heating regions of the power module 11c are allocated on the left and right sides of the power module 11c while placing their central portions therebetween. Therefore, because the boss 21b is easy to separate cooling water into the left and right areas of the cooling jacket 21 as described above, the heating regions of the power module 11c can be effectively cooled.

As indicated by black arrows of the diagram, because the bosses 21b are arranged on the central areas of the back side of the cooling jacket 21 along Y-axis of the diagram, turbulent flows of cooling water are easy to occur around the bosses 21b. Because cooling water is moderately agitated by the turbulent flow, an effect conducive to improvement of cooling efficiency can be obtained.

In comparison to when the bosses 21b are not provided by uniformly providing the radiation fins 21c on the back side of the cooling jacket 21, the case where the bosses 21b are provided can reduce a pressure loss because a contact area with cooling water on the back side of the cooling jacket 21 becomes small.

In comparison to when the bosses 21b are not provided at all, the present embodiment obtains a validation result that the pressure loss is reduced by 5% as experimental data of the case where the three bosses 21b are provided as illustrated in FIG. 5. The validation result is explained in detail by "the first validation example" to be described later.

Therefore, the power conversion apparatus 10 according to the embodiment can separate cooling water into the left and right areas of the cooling jacket 21 and enhance the flow velocity in the left and right areas and thus can improve cooling efficiency and also reduce a pressure loss. In other words, it is possible to keep balance of cooling efficiency and pressure loss of the cooling mechanism 20.

In FIG. 5, it has been explained that cooling water is easily separated into the left and right areas of the cooling jacket 21 by arranging the bosses 21b in the central areas of the back side of the cooling jacket 21 along Y-axis of the diagram. In addition to this, a mechanism that separates cooling water may be further provided.

For example, the boss 21b may have fins that extend in the directions of the black arrows of FIG. 5. Alternatively, fins substantially vertical to the flow direction of cooling water may be provided between the bosses 21b.

Till now, it has been explained that the bosses 21b corresponding to the power modules 11c are provided as an example. So-called dummy bosses 21b' not corresponding to the power module 11c may be provided in the central areas of the back side of the cooling jacket 21.

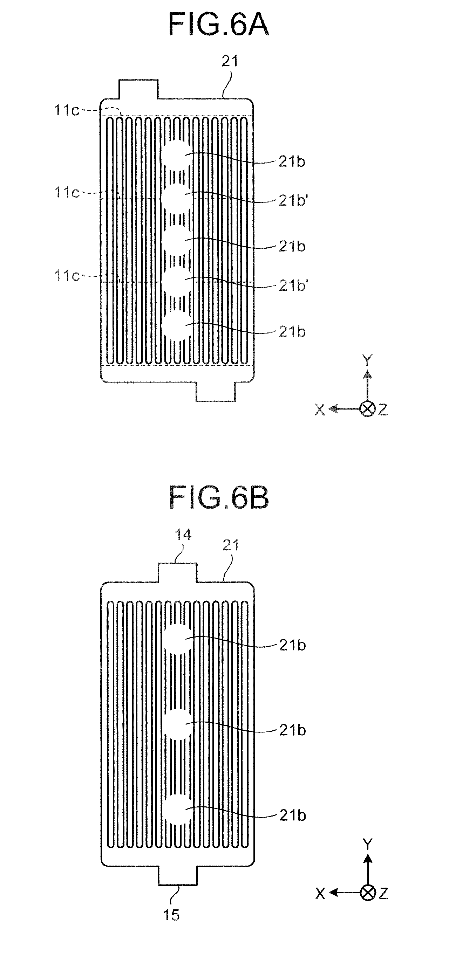

This alternative example will be explained with reference to FIG. 6A. FIG. 6A is a schematic diagram illustrating an alternative example in which the dummy bosses 21b' are provided.

As illustrated in FIG. 6A, the power conversion apparatus 10 can be provided with the bosses 21b' not corresponding to the power module 11c in the central areas of the back side of the cooling jacket 21. In other words, the bosses 21b' are protrusions that do not function as bolt receiving of the bolt B for fixing the power module 11c.

Therefore, the bosses 21b' function to keep balance of cooling efficiency and pressure loss of the cooling mechanism 20. In FIG. 6A, it has been illustrated that the bosses 21b' are provided between the bosses 21b at equal intervals from the bosses 21b. However, the present embodiment is not limited to this. Moreover, the number of the bosses 21b' is not limited to this.

In other words, it is only necessary that the bosses 21b' are arranged at positions at which balance of cooling efficiency and pressure loss is optimized. It is only necessary that the arrangement positions are determined on the basis of a simulation result in a design process of the power conversion apparatus 10, experimental data of a verification process, or the like.

Till now, it has been explained that the water-supply pipe 14 and the drainage pipe 15 are arranged to be diagonally opposite each other. They may be arranged to be opposite to each other.

This alternative example will be explained with reference to FIG. 6B. FIG. 6B is a schematic diagram illustrating an alternative example in which the water-supply pipe 14 and the drainage pipe 15 are arranged opposite each other.

As illustrated in FIG. 6B, when the bosses 21b are arranged in the central areas of the back side of the cooling jacket 21, cooling water is separated into the left and right areas of the cooling jacket 21 and is easily agitated as described above.

Therefore, even if the water-supply pipe 14 and the drainage pipe 15 are arranged opposite each other, the power module 11c can be effectively cooled without reducing cooling efficiency.

To keep balance of cooling efficiency and pressure loss of the cooling mechanism 20, the arrangement position between the water-supply pipe 14 and the drainage pipe 15 may be considered. In other words, while considering the arrangement position between the water-supply pipe 14 and the drainage pipe 15 in addition to the arrangement position and the number of the bosses 21b and the bosses 21b' described above, it is only necessary to adjust cooling efficiency and pressure loss so that balance of them is optimized.

It is obvious that other components that constitute the cooling mechanism 20 can be added to perform this adjustment. Although it is not illustrated, the length of protrusion of the radiation fin 21c may be added, for example. In relation to this, the length of protrusion of the boss 21b relative to the length of protrusion of the radiation fin 21c may be added. For example, assuming that the length of protrusion of the boss 21b is shorter than the length of protrusion of the radiation fin 21c, an effect of weight saving can be obtained.

Conversely, the length of protrusion of the boss 21b may be longer than the length of protrusion of the radiation fin 21c. Incidentally, in the present embodiment, the validation result of this case shows enhancement of cooling efficiency. The validation result is indicated by "the second validation example" to be described later.

Till now, it has been explained that the bosses 21b or the bosses 21b' are serially arranged in the central portions of the cooling jacket 21. However, the present embodiment is not limited to this. For example, zigzag arrangement may be performed.

Next, the first and second validation examples of the present embodiment are explained. In the first and second validation examples, the cooling jacket 21 of the same type as that of FIGS. 4A and 4B was used, whose outside dimension is 200mm (length: Y direction) * 60mm (width: X direction) * 20mm (height: Z direction) and rated flow is 10L/min.

### First Validation Example

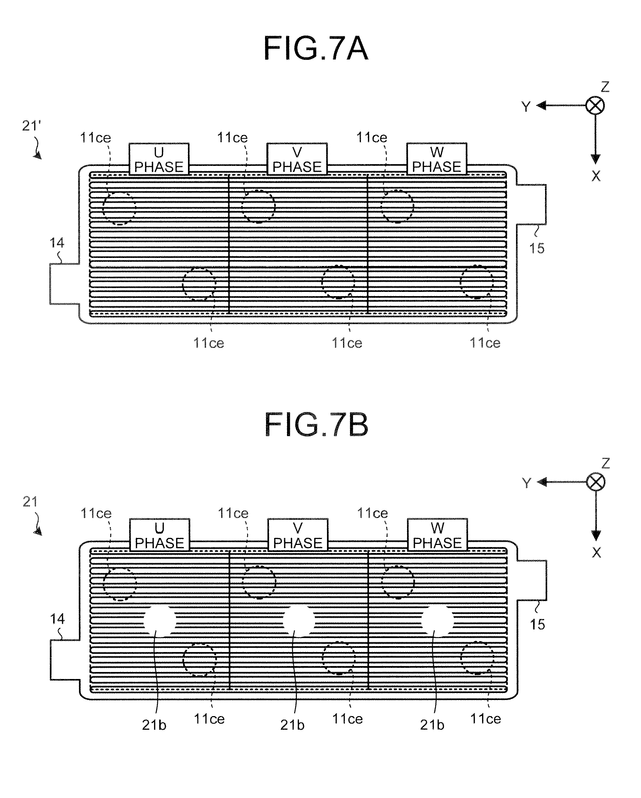

FIGS. 7A and 7B are diagrams illustrating preconditions of the first validation example. First, according to the first validation example, when flow rates of cooling water are 10L/min and 20L/min in a cooling jacket 21' (hereinafter, "without boss") illustrated in FIG. 7A in which the boss 21b does not exist and the cooling jacket 21 (hereinafter, "with boss") illustrated in FIG. 7B in which the boss 21b exists, their pressure losses were compared.

In any case where flow rates are 10L/min and 20L/min, the base temperature of cooling water is 20 degrees Celsius. Moreover, measurement points of temperature are near the switching elements 11ce respectively corresponding to "U phase", "V phase", and "W phase" illustrated in FIGS. 7A and 7B. The validation result of the first validation example that is validated by the preconditions is indicated by Table 1.

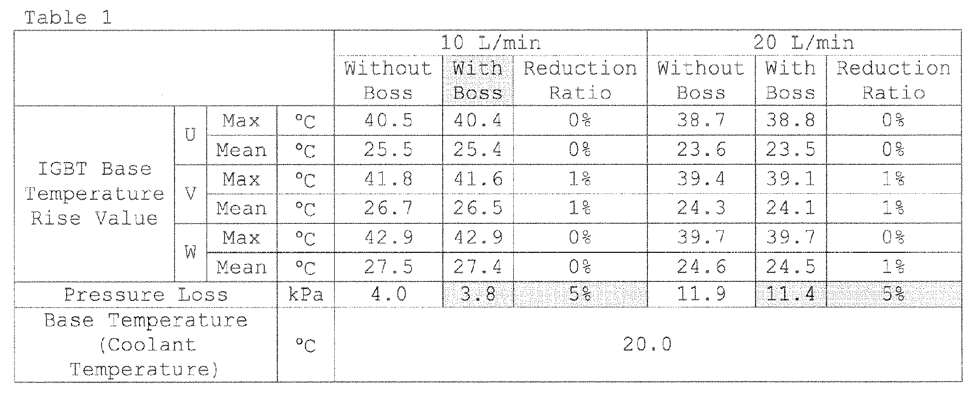

As illustrated in Table 1, in any case where a volume of cooling water is 10L/min and 20L/min, "with boss" can reduce a pressure loss by 5% as compared to "without boss". In other words, a pressure loss can be reduced by providing the boss 21b. Because a pressure loss is reduced, the load of the pump 5 is reduced and miniaturization can be performed.

### Second Validation Example

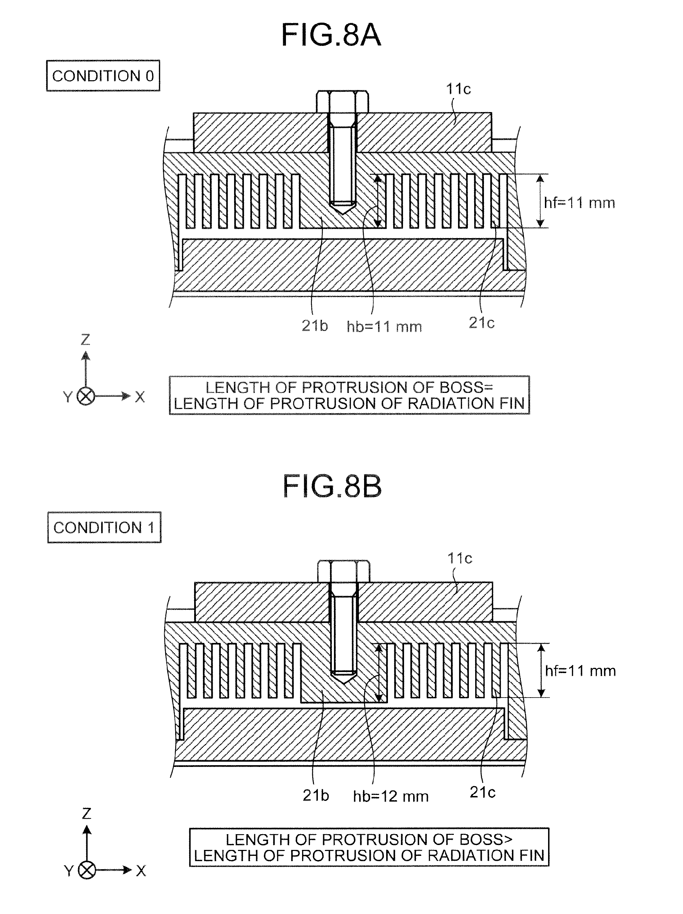

Next, FIGS. 8A to 8D are diagrams illustrating preconditions of the second validation example. Herein, FIGS. 8A to 8D are diagrams that are obtained by further simplifying the enlarged schematic diagram of FIG. 2B. In the second validation example, cooling efficiencies were validated under "Condition 0" to "Condition 3" that are obtained by taking different combinations between the length hb of protrusion of the boss 21b and the length hf of protrusion of the radiation fin 21c.

As illustrated in FIG. 8A, in "Condition 0", the length hb of protrusion of the boss 21b and the length hf of protrusion of the radiation fin 21c are together "11mm". In other words, "Condition 0" corresponds to the case where "the length hb of protrusion of the boss 21b = the length hf of protrusion of the radiation fin 21c". This "Condition 0" is considered as a "default".

As illustrated in FIG. 8B, in "Condition 1", the length hb of protrusion of the boss 21b is "12mm" that is obtained by adding 1mm to the default. Moreover, the length hf of protrusion of the radiation fin 21c is "11mm" that is equal to the default. In other words, "Condition 1" corresponds to the case where "the length hb of protrusion of the boss 21b > the length hf of protrusion of the radiation fin 21c".

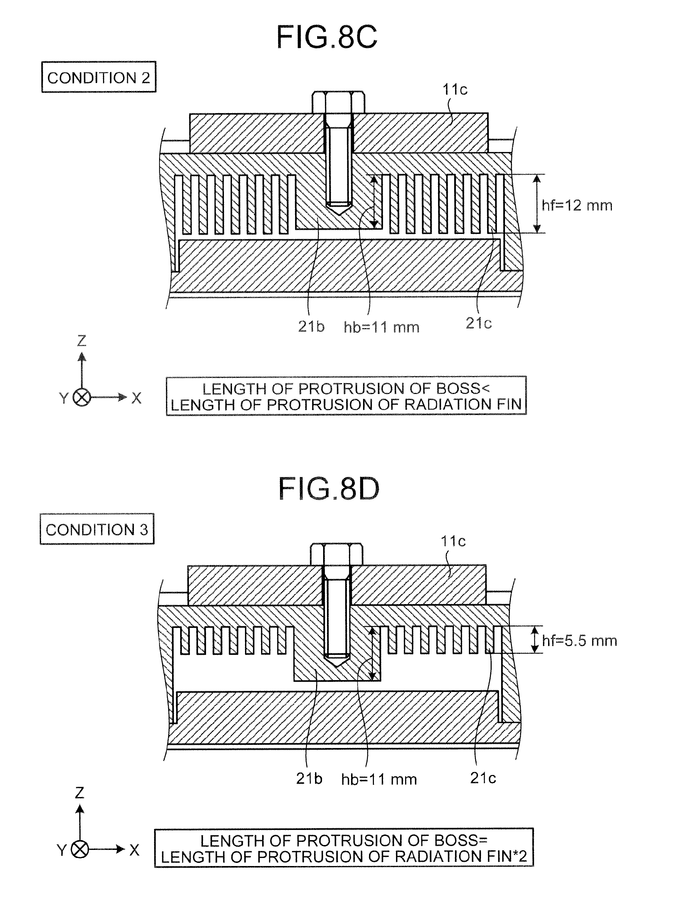

As illustrated in FIG. 8C, in "Condition 2", the length hb of protrusion of the boss 21b is "11mm" that is equal to the default. Moreover, the length hf of protrusion of the radiation fin 21c is "12mm" that is obtained by adding 1mm to the default. In other words, "Condition 2" corresponds to the case where "the length hb of protrusion of the boss 21b < the length hf of protrusion of the radiation fin 21c".

As illustrated in FIG. 8D, in "Condition 3", the length hb of protrusion of the boss 21b "11mm" that is equal to the default. Moreover, the length hf of protrusion of the radiation fin 21c is "5.5mm" that is obtained by taking the half of the length of the default. In other words, "Condition 3" corresponds to the case where "the length hb of protrusion of the boss 21b = the length hf of protrusion of the radiation fin 21c *2".

In any case of "Condition 0" to "Condition 3", the temperature of cooling water in the water-supply pipe 14 (inlet) is 65 degrees Celsius and its flow rate is 10L/min. Moreover, similarly to the first validation example, the measurement points of temperature are near the switching elements 11ce respectively corresponding to "U phase", "V phase", and "W phase" (see FIGS. 7A and 7B). The validation result of the second validation example that is validated by the preconditions is indicated by Table 2.

**Table 2**

| Each Measurement Point | Unit | Condition 0 Default | | Condition 1 Boss + 1 mm | | Condition 2 Fin + 1 mm | | Condition 3 Fin 1/2 mm | |
|---|---|---|---|---|---|---|---|---|---|
| | | Max | Mean | Max | Mean | Max | Mean | Max | Mean |
| Water | °C | 65 | | 65 | | 65 | | 65 | |
| U (Average) | °C | 124.0 | 118.5 | 120.6 | 114.9 | 121.8 | 116.1 | 125.2 | 119.4 |
| V (Average) | °C | 124.2 | 118.6 | 120.6 | 114.9 | 121.5 | 115.8 | 124.6 | 118.8 |
| W (Average) | °C | 122.4 | 116.9 | 119.3 | 113.5 | 119.5 | 113.8 | 122.5 | 116.7 |

As illustrated in Table 2, "Condition 1" can largely improve cooling efficiency as compared to "Condition 0". Moreover, "Condition 2" can also improve cooling efficiency as compared to "Condition 0". Herein, cooling efficiency of "Condition 2" is lower than that of "Condition 1". However, in case of "Condition 2", the pressure loss is slightly increased as compared to "Condition 0" and "Condition 1" because the boss 21b is short relatively to the radiation fin 21c and thus a contact area with cooling water increases as the radiation fin 21c becomes longer.

"Condition 3" can obtain a cooling effect substantially equal to that of "Condition 0". Moreover, "Condition 3" can considerably reduce a pressure loss because a contact area between the radiation fin 21c and cooling water can be considerably reduced.

According to the validation result of the second validation example, at least in case of "the length hb of protrusion of the boss 21b ≥ the length hf of protrusion of the radiation fin 21c", cooling efficiency can be improved and a pressure loss can be moderately reduced. In other words, it is possible to keep balance of cooling efficiency and pressure loss of the cooling mechanism 20.

As described above, the power conversion apparatus according to the embodiment includes the cooling jacket. The cooling jacket includes the mounting face on which the power module including a power semiconductor device is mounted, the plurality of radiation fins that are arranged along a predetermined direction over the substantially whole area of the back side of the mounting face, and the boss that is placed along the predetermined direction in the central area of the substantially whole area of the back side.

Therefore, according to the power conversion apparatus according to the embodiment can keep balance between cooling efficiency and pressure loss of the cooling mechanism.

In the embodiment described above, it has been explained that the power module includes IGBT as a switching element and FWDi as a rectifying device as an example. However, the present embodiment is not limited to this. For example, the power module may include a metal oxide semiconductor field effect transistor (MOSFET) and a Schottky barrier diode (SBD).

## Claims

1. A power conversion apparatus (10) comprising a cooling jacket (21), the cooling jacket (21) comprising:
a mounting face on which a power module (11c) including a power semiconductor device is mounted;
a plurality of radiation fins (21c) that are arranged along a predetermined direction over a substantially whole area of a back side of the mounting face; and
a boss (21b) that is placed along the predetermined direction in a central area of the substantially whole area of the back side.

2. The power conversion apparatus (10) according to claim 1, wherein
a through-hole (11cb) is formed in a central portion of a principal surface of the power module (11c), and
a hole (21a) into and to which a fastening member (B) inserted into through the through-hole (11cb) is inserted and fixed is formed in the mounting face of the boss (21b).

3. The power conversion apparatus (10) according to claim 1 or 2, wherein
the cooling jacket (21) has, of surfaces facing each other in the predetermined direction among external surfaces of the cooling jacket (21), a water-supply inlet (14) for a cooling medium in the one surface and a drainage outlet (15) for the cooling medium in the other surface, and
the water-supply inlet (14) and the drainage outlet (15) are arranged at respective alternate positions.

4. The power conversion apparatus (10) according to any one of claims 1 to 3, wherein the boss (21b) is provided so that a length (hb) of protrusion of the boss is not less than a length (hf) of protrusion of the radiation fin.
